# EUROPEAN PATENT APPLICATION

(11) **EP 4 059 367 A1**
(43) Date of publication of application: **21.09.2022**
(21) Application number: 21163110.6
(22) Date of filing: 17.03.2021
(51) Int. Cl.: A24F 40/60

(54) **AEROSOL GENERATION DEVICE WITH CAPACITIVE TOUCH INTERFACE**

(71) Applicant: JT International SA, 1202 Geneva (CH)
(72) Inventor: ADAIR, Kyle, Lisburn, County Antrim, BT28 2UW (GB); POPOOLA, Olayiwola Olamiposi, Walton-on-Thames, KT12 2SJ (GB); LOVEDAY, Peter, Woking, GU24 9PW (GB)
(74) Representative: Bardehle Pagenberg Partnerschaft mbB Patentanwälte Rechtsanwälte

(57) **Abstract**

The present invention relates to an aerosol generating device (1) allowing a user to consume a consumable contained in a cartomizer (2), comprising: a casing (11) comprising a power supply unit and a receiving cavity for receiving the cartomizer (2); an outer wall (12) comprising or preferably made of glass material, on at least an external surface of the casing (11); and a capacitive touch interface (13) comprising at least one capacitive sensor (131) positioned under the outer wall (12); wherein the capacitive touch interface (13) is configured to sense a capacitive coupling generated by a touching of the outer wall (12) by a finger of a user.

## Description

### TECHNICAL FIELD

The present invention is directed to an aerosol generation device. More specifically, the present invention is directed to an aerosol generation device with a capacitive touch interface.

### BACKGROUND

An aerosol generation device, or E-cigarette, is now a mainstream product to simulate a traditional tobacco cigarette. There are many types of aerosol generation devices, and the one which still has tobacco or volatile substrate inside is one of the most popular types. By heating but not burning the consumable, this one type of the aerosol generation device does not release the by-products of combustion such as tar and carbon monoxide. The operation method of the aerosol generation device is to contain an aerosol generation carrier inside and to heat it, but not to its burning point. There is also another type of E-cigarette, the operation method of which is to evaporate liquid to form smoke. For both types of aerosol generation devices, a compact, portable and easy-to-use design is important.

The current aerosol generation devices are usually arranged with buttons having gaps in-between the device, which makes the devices vulnerable for, for example, wet air, dust, liquids in daily life, and bits from the consumable. There is also a desire to improve the strength, ability to contain flaws, and crack-resistance for the material used in the housing and the surface of the button used in the conventional aerosol generation device.

### SUMMARY OF THE INVENTION

The present invention provides a smoking article for an aerosol generation device, which solves some of or all of the above problems.

A 1st embodiment of the invention is directed to an aerosol generating device allowing a user to consume a consumable contained in a cartomizer, comprising:
- a casing comprising a power supply unit and a receiving cavity for receiving the cartomizer;
- an outer wall comprising or preferably made of glass material, on at least an external surface of the casing; and
- a capacitive touch interface comprising at least one capacitive sensor positioned under the outer wall;
wherein the capacitive touch interface is configured to sense a capacitive coupling generated by a touching of the outer wall by a finger of a user.

Using a glass material for the housing of the aerosol generation device having a capacitive sensing touching button provides a more integrated design for the device, which avoids the gaps between the conventional buttons and the housing of the device, and improves the water- and dust-proof performance.

According to a 2nd embodiment, in the 1st embodiment, the outer wall comprises at least one permanent visual indicator in the area above the at least one capacitive sensor, which indicates to the user an operation performed by the aerosol generating device and/or a position for the user to touch for operation when the finger of the user touches the outer wall in the area.

With this arrangement, the device can have a simple structure for operation than having a touch-screen display arranged therein, while the user easily recognizes the operation from the device he intended to perform.

According to a 3rd embodiment, in the preceding embodiment, the at least one indicator is formed by a light-transparent sub-area and a light-opaque sub-area of the area above the at least one capacitive sensor.

With this arrangement, the position and, preferably, the function of the capacitive buttons can be realized by the user, and the user can discern the buttons even in the dark with a light arranged underneath the light-transparent sub-area.

According to a 4th embodiment, in the preceding embodiment, the capacitive touch interface comprises an LED configured to illuminate the area of the outer wall located above the at least one capacitive sensor.

According to a 5th embodiment, in the preceding embodiment, the capacitive touch interface comprises a light guide configured to diffuse light emitted by the LED.

According to a 6th embodiment, in any one of the preceding embodiments, the glass material has a Young's modulus of at least 70 MPa, preferably at least 74 MPa, more preferably at least 78 MPa and most preferably at least 80 MPa, and of at most 94 MPa, preferably at most 90 MPa, more preferably at most 86 MPa and most preferably at most 82 MPa.

According to a 7th embodiment, in any one of the preceding embodiments, the glass material has a yield strength of at least 95 MPa, preferably at least 200 MPa, more preferably at least 300 MPa and most preferably at least 400 MPa, and of at most 800 MPa, preferably at most 700 MPa, more preferably at most 600 MPa and most preferably at most 500 MPa.

According to an 8th embodiment, in any one of the preceding embodiments, the glass material has a dielectric constant of at least 7, preferably at least 7.5, more preferably at least 8, and most preferably at least 8.5, and of at most 10.5, preferably at most 10, more preferably at most 9.5 and most preferably at most 9 at 1 MHz.

According to a 9th embodiment, in any one of the preceding embodiments, the average thickness of the outer wall is at least 0.3 mm, preferably at least 0.4 mm, more preferably at least 0.5 mm and most preferably at least 0.55 mm, and at most 1 mm, preferably at most 0.9 mm, more preferably at most 0.8 mm and most preferably at most 0.7 mm.

According to a 10th embodiment, in any one of the preceding embodiments, the glass material is an alkali-aluminosilicate material.

The above arrangements allow the outer wall to have a small size while still being capable of letting the underlaying captative sensor sense the touch of the user.

According to an 11th embodiment, in any one of the preceding embodiments, the capacitive touch interface comprises a flexible printed circuit extending below the outer wall.

According to a 12th embodiment, in any one of the preceding embodiments, the at least one capacitive sensor comprises a series of the capacitive sensors aligned in the longitudinal direction of the device.

According to a 13th embodiment, in any one of the preceding embodiments, the casing (11) comprises an opening, and the outer wall (12) is hermetically mounted on the opening.

This arrangement improves the water- and dust-proof performance of the device.

According to a 14th embodiment of the invention, in any one of the preceding embodiments, the outer wall extends in the longitudinal direction along at least 60% of the length, preferably at least 70% of the length, more preferably at least 80% of the length, in particular at least 95% of the length, and most preferably substantially the whole length of the device.

This arrangement improves the integration of the device.

According to a 15th embodiment of the invention, in any one of the preceding embodiments, the outer wall is a plate of glass material.

According to a 16th embodiment of the invention, in any one of the preceding embodiments, the outer wall (12) is configured to form substantially the entire external surface of the casing.

Preferred embodiments are now described, by way of example only, with reference to the accompanying drawings.

### BRIEF DESCRIPTION OF THE DRAWINGS

- Figure 1:: is an exploded schematic illustration view of an aerosol generation device according to an exemplary embodiment of the present invention;
- Figure 2:: shows a partial and enlarged schematic illustration of the aerosol generation device, with details of the capacitive touch interface according to the exemplary embodiment of the present invention;
- Figure 3:: shows a partial and enlarged cross section view of the aerosol generation device, with details of the capacitive touch interface according to the exemplary embodiment of the present invention.

### DETAILED DESCRIPTION OF THE PREFERRED EMBODIMENTS

Preferred embodiments of the present invention are described hereinafter and in conjunction with the accompanying drawings.

As used herein, the term "aerosol generation device" or "electronic cigarette" may include an electronic cigarette configured to deliver an aerosol to a user, including an aerosol for smoking. "Printed circuit board" or "PCB" are well-known terms for the skilled person, which supports and uses etched conductive tracks (trace, lines), pads and other features, to electrically connect electrical or electronic components. Herein, "PCB" may also mean Printed Circuit Board Assembly (PCBA), which means the substrate of the PCB board and the components thereon. The illustrated embodiments of the aerosol generation system and the PCB therein are schematic, and it is also possible to combine some of the parts to single units or elements, which will be apparent to a person skilled in the art. Herein, "coupled" or "connected" may mean "electronically coupled" or "electronically connected", wherein the connection may be via other components such as transistors or capacities for purposes known to the skilled person. "Printed circuit board substrate" may refer to the printed circuit board per se, namely the combination of the unconducive substrate layer and the copper layer, which makes the circuit board, or the unconducive substrate layer per se, without the components mounted or soldered thereon.

In the description of the present invention, it should be understood that the terms "one end", "the other end", "outer side", "upper", "above", "inner side", "under", "below", "horizontal", "coaxial", "central", "end" "part", "length", "outer end" etc., which indicate the orientation or positional relationship, are based on the orientation or positional relationship shown in the drawings. The terms such as "upper", "above", "below", "under" and the like used in the present invention to indicate a relative position in space are used for the purpose of facilitating explanation to describe a unit or feature shown in the drawings relative to the relationship of another unit or feature. The term of the relative position in space may be intended to include different orientations of the device in use or operation other than those shown in the figures. For example, if the device in the figure is turned over, the unit described as being "below" or "under" other units or features will be "above" the other units or features. Therefore, the exemplary term "below" can encompass both the above and below orientations. The device can be oriented in other ways (rotated by 90 degrees or other orientations), and the space-related descriptors used herein are explained accordingly. More specifically, the word "above" means that one unit or element is arranged or configured relatively in an exterior direction of the device towards the (an)other unit(s) or element(s); the word "below" means that one unit or element is arranged or configured relatively in an interior direction of the device towards the other units or elements.

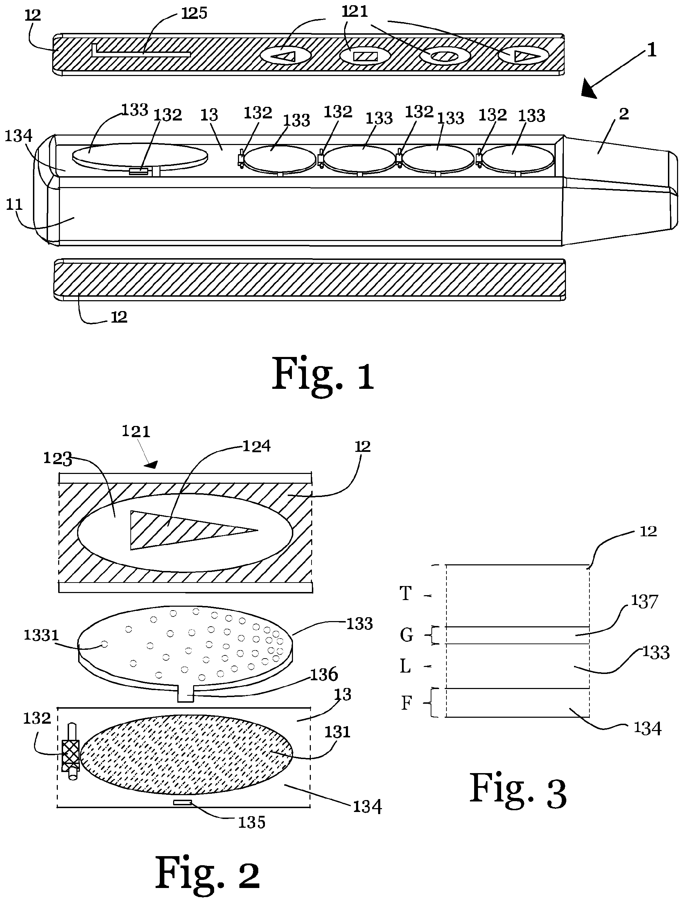

Fig. 1 shows an exploded schematic view of an aerosol generation device 1 and a cartridge 2 according to an exemplary embodiment. The aerosol generation device 1 has an elongated shape, preferably a substantially cuboid shape. The cartridge 2, which is inserted in the device 1 in figure 1, comprises a mouthpiece part and a consumable container (not shown) containing the consumable, which is in the form of a liquid. The liquid can be inhaled by a user from the mouthpiece part with the power support of the device 1. The liquid typically comprises an aerosol-forming substance, such as glycerin or propylene glycol that creates the vapor. Other common substances in the liquid are nicotine and various flavorings. In other embodiments, other common consumables, such as a substrate having nicotine, can be used and inserted into the aerosol generation device 1 for consuming.

The aerosol generation device 1 comprises an outside casing 11 as the housing of the device 1, at least one outer wall 12, in the present embodiments two outer walls 12, and a capacitive touch interface 13. The outside casing 11 comprises a cavity to receive the cartridge 2 at one end, and a chassis therein (not shown). A cartridge socket integrated with the internal chassis is configured to hold and electronically connect or heat the cartridge 2 at the cavity end. The electric power is transmitted from a preferably LiPo battery through a PCBA to the cartridge socket, which are all electrically connected with each other. The LiPo battery can be charged through a USB port. The PCBA, the LiPo battery, the USB port are mounted together on the inner chassis 14 and comprised by the outer casing 11. The outer casing 11 of the aerosol generation device 1 comprises a frame which is preferably made of rigid material. The frame 11 substantially has a U-shape, a cuboid shape having multiple surfaces, preferably three or four surfaces, or substantially a " 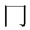 " shape, with two substantially right-angle corners close at the cavity end, and two rounded or curved corners arranged at the base end, which is the end opposite to the cavity end. The frame 11 forms three circumferential side surfaces. One of the circumferential surfaces is the base end. Two openings or windows are comprised by the frame on two opposite surfaces substantially perpendicular to the frame. The frame 11 may form the bezel of the outer walls 12, which has a substantially squircle shape. The outer walls 12 are sealingly or hermetically mounted on, fixed in or attached to the openings or the windows of the outer casing 11 so that the PCBA, preferably FPC (flexible printed circuit board), can be disposed underneath the outer wall 12 and inside the casing 11. The openings or the windows of the frame, namely the outer walls 12, extend in the longitudinal direction along at least 60% of the length, preferably at least 70% of the length, more preferably at least 80% of the length, in particular at least 95% of the length, and most preferably substantially the whole length of the device 1. This improves the ingress protection for the aerosol generation device 1.

The outer casing 11 of the aerosol generation device 1 further comprises a capacitive touch interface 13. The capacitive touch interface 13 is arranged parallel to and underneath the outer wall 12, and perpendicular to the frame of the outside casing 11. This makes the outer wall 12 being a touch-sensitive reflective outer surface. As shown in figure 2, the capacitive touch interface 13 comprises a light guide 133, a capacitive touch sensor 131, an LED 132, preferably a side firing LED, and a PCBA 134. The capacitive touch sensor 131, which is configured to detect a user input from the touch-sensitive outer surface, and the LED 132 are electronically connected to the PCBA 134. The PCBA 134 comprises a flexible printed circuit 134 extending below the outer wall 12, electrical lines and other electrical components (not shown). The light guide 133 has preferably the same shape and a substantially equivalent area as the capacitive sensor 131, so as to illuminate the area of the outer wall located above the capacitive sensor and diffuse light emitted from the side firing LED 132 evenly and minimalize the light bleed. In the present embodiment, the capacitive sensor has a circular shape, and the light guide also has a circular shape, with a protrusion 136 which can be inserted into a hole 135 so that the light guide 133 can be fixed upon the capacitive touch sensor 131. In another embodiment, the light guides 133 can be integrated as one piece and connected with a rod. In yet another preferred embodiment, the light guides can be fixed on the top glass 12 with glue 137.

Figure 3 shows a partial and enlarged cross section view of the aerosol generation device 1, with details of the top glass 12 and parts of the capacitive touch interface having the light guide 133, the side firing LED 132 (not shown), the FPC 134, where the LEDs 132 and the capacitive sensors 131 are attached on, and selectively a glue layer 137. The light guide 133 and the LED 132 configured adjacent to or disposed along the light guide 133 are sandwiched between the top glass 12 and the FPC 134. The top glass 12 has a thickness T of at least 0.4 mm, preferably at least 0.45 mm, and more preferably at least 0.5 mm, and of at most 0.7 mm, preferably at most 0.65 mm, and more preferably at most 0.6 mm, and most preferably, at most 0.55 mm. As shown in the figure, in the preferred embodiment, adhesive or glue 137 is also applied between the light guide 133 and the top glass 12, and the approximate thickness G is at least 0.08 mm, preferably at least 0.09 mm, and at most 0.12 mm, preferably at most 0.11 mm, and most preferably at most 0.1 mm. The light guide, preferably made of acrylic, has a thickness L of at least 0.35 mm, preferably at least 0.4 mm, and more preferably at least 0.45 mm, and at most 0.65 mm, preferably at most 0.6 mm, and more preferably at most 0.55 mm, and most preferably at most 0.5 mm. The FPC, preferably made of polyamide, has a thickness F of at least 0.11 mm, preferably at least 0.12 mm, and more preferably at least 0.13 mm, and of at most 0.17 mm, preferably at most 0.16 mm, and more preferably at most 0.15 mm, and most preferably at most 0.14 mm. Therefore, the thickness of the capacitive touch interface 13 with the top glass 12 has a thickness of at least 1.0 mm, preferably at least 1.1 mm, and more preferably at least 1.2 mm, and of at most 1.6 mm, preferably at most 1.5 mm, more preferably at most 1.4 mm, and most preferably at most 1.29 mm. The LED 132, preferably a side firing RGB LED 132, is arranged adjacent to the light guide 133, so that the light inside the light guide can bounce off the edges of the light guide 133, scatters and is distributed evenly across the surface. Preferably the light guides 133 are textured differently to facilitate with light dispersion. More preferably, the light guide 133 comprises multiple diffuser dots 1331 forming a dot pattern or texture in the light guide 133, so as to, for example, redirect the light incident on the base of the light guide 133 so that it passes through the upper surface of the light guide 133. The diffuser dots 1331 or the dot pattern/texture are less dense near the side firing LED 132, as it is brighter there, and denser, as they are away from the side firing LED 132 as shown in figure 2. In other words, the dot density of the dot pattern increases along the direction of the propagation or emission of the light from the LED 132.

In order to transmit the light, the outer wall 12 comprises and is preferably made of rigid and light-transmissible material. In the present embodiment, preferably, the outer wall 12 is made of glass material. In other words, the outer wall 12 is a glass panel or a plate of glass material. More preferably, the glass material is an alkali-aluminosilicate material. Most preferably, the glass named "DRAGONTRAIL^{™}" made by AGC^{™} is used. With this material, the outer wall 12 is rigid enough and can protect the inner electrical components.

In order to sense the touch from the user, the sensor pad (marked in dashed lines) of the capacitive sensor 131 forms one side of a parallel capacitor, and the user's finger then forms the second side of the capacitor. When the user's finger touches the outer wall close to the sensor pad, the distance between the finger and the sensor pad decreases, and the capacitance increases. Hence, the sensor pad senses the touch of the user even with a non-conductive panel, which is the alkali-aluminosilicate glass panel herein, in between. To ensure that the capacitance change can be sensed by the sensor 131, the average thickness of the outer wall is at least 0.3 mm, preferably at least 0.4 mm, more preferably at least 0.5 mm and most preferably at least 0.55 mm, and at most 1 mm, preferably at most 0.9 mm, more preferably at most 0.8 mm and most preferably at most 0.7 mm.

Although outer wall 12 is preferably made of alkali-aluminosilicate material, other glass materials being rigid enough can also be used. In fact, any glass material having the following performance can be used: having a Young's modulus of at least 70 MPa, preferably at least 74 MPa, more preferably at least 78 MPa and most preferably at least 80 MPa, and of at most 94 MPa, preferably at most 90 MPa, more preferably at most 86 MPa and most preferably at most 82 MPa; having a yield strength of at least 95 MPa, preferably at least 200 MPa, more preferably at least 300 MPa and most preferably at least 400 MPa, and of at most 800 MPa, preferably at most 700 MPa, more preferably at most 600 MPa and most preferably at most 500 MPa; having a dielectric constant of at least 7, preferably at least 7.5, more preferably at least 8, and most preferably at least 8.5, and of at most 10.5, preferably at most 10, more preferably at most 9.5 and most preferably at most 9 at 1 MHz. A material having the above characteristics is rigid enough with a relatively light weight and thin profile that is able to make the sensor 131 sense a capacitive change when a user touches the plate of the material. The outer wall 12 can therefore have a desired performance of smooth textile, high conductivity, high strength and high scratch resistance.

A series of the sensors 131, together with the LEDs 132 and light guides 133, are arranged along the insertion direction of the cartridge 2 or along the elongated direction of the elongated frame, namely aligned in the longitudinal direction of the device 1 if the insertion direction is regarded as the longitudinal direction. With this arrangement, multiple capacitive touch buttons can be set with a relatively large sensing area.

In order to let the user know where the capacitive button(s) is/are, the glass panel 12 is coated with prints or printed with symbol(s) as a permanent visual indicator 121 preferably on the side close to the capacitive touch interface. In other embodiments, the print is formed on the outer surface of the outer wall 12. The area having the sensors is coated with light-transmittable or light-transparent prints, or not coated with any material on the glass, while areas not having the sensors are preferably coated with light-opaque material or prints, so that the user recognizes the area of the glass panel 12 the user should touch on. The light-transmittable sub area or transparent sections allows the light to shine through. The light-opaque sub-area, or the screen-printed sections are printed in black. In other embodiments, the light-opaque sub-area can have a silver or white backing, which reduces the transparency even further. In other words, although it is named as a light-opaque sub area, it can also be a light-translucent sub-area, which gives a crisper definition of light. Further, in preferred embodiments, when multiple capacitive buttons are set for multiple functions of or different operations performed by the device 1, multiple light-transparent sub-areas 123 are selectively set and interleaved above the sensors 131 at certain points as permanent visual indicators 121, in which light-opaque sub-areas 124, for blocking the light from the LEDs 132, with specific symbols, icons, letters or patterns indicating the specific functions relating to the buttons are arranged. With such an arrangement, the logo and symbols on the outer surface can be selectively illuminated. For example, as shown in figure 2, a symbol which forms the light-opaque sub-area having a triangle arrow pointing towards the cavity of the frame may indicate to the user that if the user wants to eject the cartridge 2 after consuming, the user can touch the scope of that sub-area with a finger. The user can easily see and touch the button because of the light transmitted from the light-transparent sub-area. The sensor then senses a capacitance change and transmits the information or data to a controller on the PCBA 134, to trigger the respective function of ejecting the cartridge 2 out of the device 1. The RGB LED 132 may emit light in a different color in the meantime, indicating that the operation is under process.

In some embodiments, as shown in figure 1, in the capacitive touch interface 13, with a light guide 133 and an LED, and without a sensor 131 set underneath may also set with a light-transparent sub-area 125 so as to show the brand, the type or other information about the device 1. Thus, the transparent sections of the logo allow the light to shine through.

## Claims

1. Aerosol generating device (1) allowing a user to consume a consumable contained in a cartomizer (2), comprising:
- a casing (11) comprising a power supply unit and a receiving cavity for receiving the cartomizer (2);
- an outer wall (12) comprising or preferably made of glass material, on at least an external surface of the casing (11); and
- a capacitive touch interface (13) comprising at least one capacitive sensor (131) positioned under the outer wall (12);
wherein the capacitive touch interface (13) is configured to sense a capacitive coupling generated by a touching of the outer wall (12) by a finger of a user.

2. Aerosol generating device (1) according to claim 1, wherein the outer wall (12) comprises at least one permanent visual indicator (121) in the area above the at least one capacitive sensor (131) which indicates to the user an operation performed by the aerosol generating device (1) and/or a position for the user to touch for operation when the finger of the user touches the outer wall (12) in the area.

3. Aerosol generating device (1) according to claim 2, wherein the at least one indicator is formed by a light-transparent sub-area (123) and light-opaque sub-area (124) of the area above the at least one capacitive sensor (131).

4. Aerosol generating device (1) according to any one of preceding claims, wherein the capacitive touch interface (13) comprises an LED (132) configured to illuminate the area of the outer wall (12) located above the at least one capacitive sensor (131).

5. Aerosol generating device (1) according to the preceding claim, wherein the capacitive touch interface (13) comprises a light guide (133) configured to diffuse light emitted by the LED (132).

6. Aerosol generating device (1) according to any one of preceding claims, wherein the glass material has a Young's modulus of at least 70 MPa, preferably at least 74 MPa, more preferably at least 78 MPa and most preferably at least 80 MPa, and of at most 94 MPa, preferably at most 90 MPa, more preferably at most 86 MPa and most preferably at most 82 MPa.

7. Aerosol generating device (1) according to any one of preceding claims, wherein the glass material has a yield strength of at least 95 MPa, preferably at least 200 MPa, more preferably at least 300 MPa and most preferably at least 400 MPa, and of at most 800 MPa, preferably at most 700 MPa, more preferably at most 600 MPa and most preferably at most 500 MPa.

8. Aerosol generating device (1) according to any one of preceding claims, wherein the glass material has a dielectric constant of at least 7, preferably at least 7.5, more preferably at least 8, and most preferably at least 8.5, and of at most 10.5, preferably at most 10, more preferably at most 9.5 and most preferably at most 9 at 1 MHz.

9. Aerosol generating device (1) according to any one of preceding claims, wherein the average thickness of the outer wall is at least 0.3 mm, preferably at least 0.4 mm, more preferably at least 0.5 mm and most preferably at least 0.55 mm, and at most 1 mm, preferably at most 0.9 mm, more preferably at most 0.8 mm and most preferably at most 0.7 mm.

10. Aerosol generating device (1) according to any one of preceding claims, wherein the glass material is an alkali-aluminosilicate material.

11. Aerosol generating device (1) according to any one of preceding claims, wherein the at least one capacitive sensor (131) comprises a series of the capacitive sensors (131) aligned in the longitudinal direction of the device (1); and
the capacitive touch interface (13) comprises a flexible printed circuit (134) extending below the outer wall.

12. Aerosol generating device (1) according to any one of the preceding claims, wherein the casing (11) comprises an opening, and the outer wall (12) is hermetically mounted on the opening.

13. Aerosol generating device (1) according to any one of the preceding claims, wherein the outer wall (12) extends in the longitudinal direction along at least 60% of the length, preferably at least 70% of the length, more preferably at least 80% of the length, in particular at least 95% of the length, and most preferably substantially the whole length of the device (1).

14. Aerosol generating device (1) according to any of the preceding claims, wherein the outer wall (12) is a plate of glass material.

15. Aerosol generating device (1) according to any one of the preceding claims, wherein the outer wall (12) is configured to form substantially the entire external surface of the casing (11).
